(19) Europäisches Patentamt

European Patent Office

Office européen des brevets

(11) EP 0 773 437 B1

(12) **EUROPEAN PATENT SPECIFICATION**

(45) Date of publication and mention
of the grant of the patent:
**12.05.2004 Bulletin 2004/20**

(51) Int Cl.⁷: **G01K 7/01**, G02B 7/36,
G02B 7/02, G02B 7/30

(21) Application number: **96402384.0**

(22) Date of filing: **08.11.1996**

(54) **Temperature sensing device and applications thereof**

Temperaturfühleranordnung und Verwendungen derselben

Capteur de température et utilisations de ce capteur

(84) Designated Contracting States:
**DE FR GB**

(30) Priority: **10.11.1995 JP 29252795**

(43) Date of publication of application:
**14.05.1997 Bulletin 1997/20**

(73) Proprietor: **SONY CORPORATION**
**Tokyo (JP)**

(72) Inventor: **Maki, Yasuhito**
**Shinagawa-ku, Tokyo (JP)**

(74) Representative: **Thévenet, Jean-Bruno et al**
**Cabinet Beau de Loménie**
**158, rue de l'Université**
**75340 Paris Cédex 07 (FR)**

(56) References cited:
**EP-A- 0 531 615        US-A- 5 412 448**

• **MANARESI N ET AL: "MOSFET THRESHOLD**
**EXTRACTION CIRCUIT" ELECTRONICS**
**LETTERS, vol. 31, no. 17, 17 August 1995, page**
**1434/1435 XP000528962**

## EP 0 773 437 B1

### Description

### BACKGROUND OF THE INVENTION

**Field of the Invention**

This invention relates to a temperature sensing device, a semiconductor device having this temperature sensing device installed therein and an auto-focusing (AF) system using this semiconductor device.

**Description of Related Art**

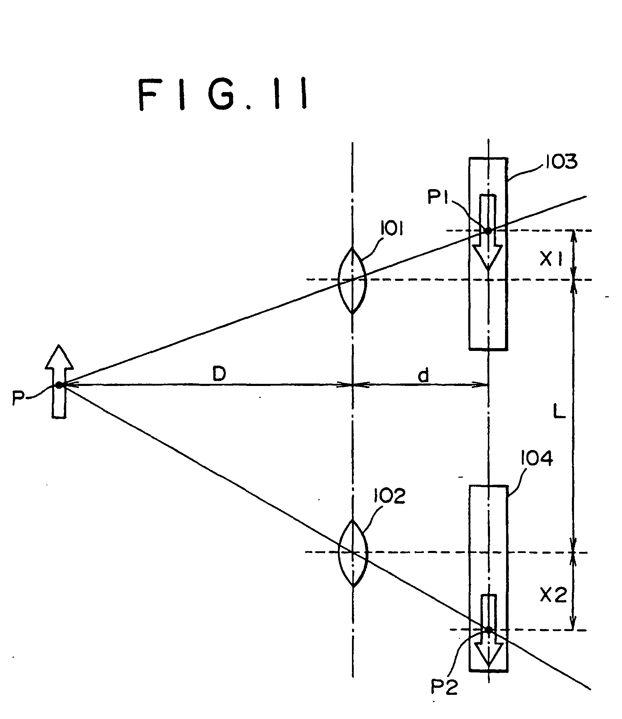

As one of the applications of a solid-state imaging device, for example, a CCD (Charge Coupled Device) linear sensor, there is provided an auto-focusing sensor (hereinafter called an AF sensor). In a simple AF sensor, a so-called triangle measuring system is applied for calculating a distance. That is, as shown in Fig. 11, there are provided two lenses 101, 102 spaced apart by a specified distance L and, further, there are arranged two CCD linear sensors 103, 104 spaced apart by a specified distance (d) and corresponding to these lenses 101, 102, respectively. When an object P is focused on the CCD linear sensors 103, 104 through the lenses 101, 102, the distances X1, X2 between the respective center points of the lenses 101, 102 and the respective image focusing points P1, P2 are calculated in response to each of the output signals, and then the position of each of the lenses 101, 102 in the direction of its optical axis is automatically controlled so as to satisfy equation 1 below.

$$D = d \times \{L/(X1 + X2)\} \qquad \text{Equation 1}$$

In the aforesaid AF sensor, plastic lenses are normally used in order to make a low-cost assembly. However, in recent years, a tendency has developed to use CCD sensors with a multi-pixel high density characteristic in order to manufacture a high precision AF sensor. In this case, error due to variation in strain (aberration) caused by temperature in the optical system of such a lens cannot be ignored, resulting in a need to correct the error. Because of this, it becomes necessary to provide a temperature sensing device for use in sensing variations in temperature. It is advantageous to install the temperature sensing device on the CCD chip for cost and space=saving reasons and, furthermore, the installation of the temperature sensor on the chip enables the temperature of the AF sensor by itself to be measured accurately, so that the correction accuracy may also be improved.

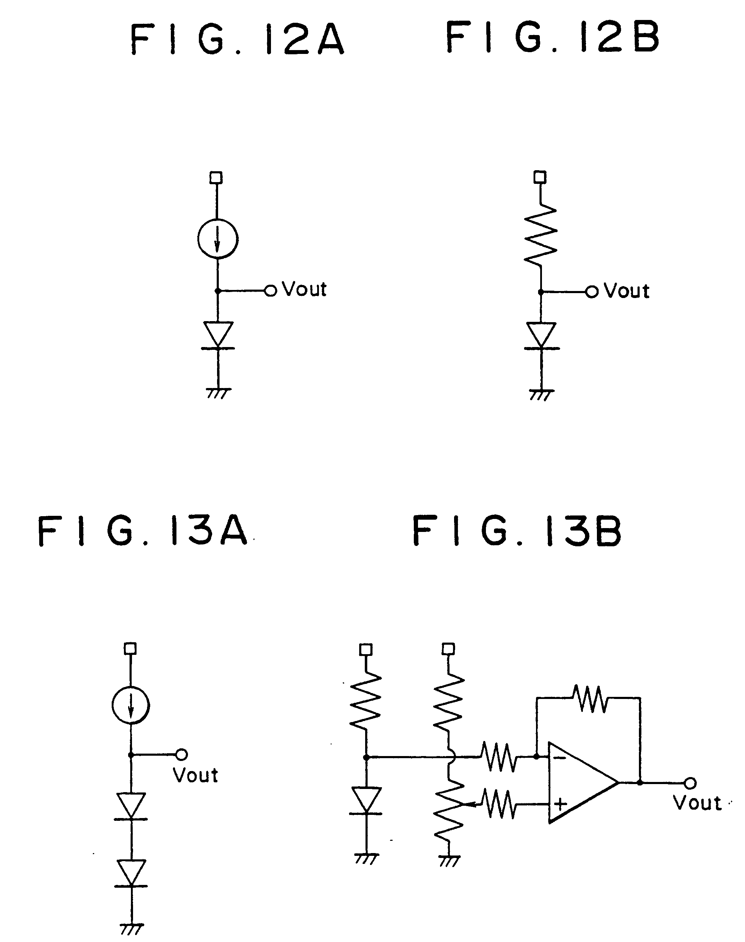

As shown in Fig. 12A and Fig. 12B, it is well known to provide the type of temperature sensing device in which a normal electrical current flows in a pn-junction diode. The variation in forward direction on-voltage (a turn-on voltage) is then detected. Although in the case of silicon Si the forward direction on-voltage of the pn-junction diode indicates a junction voltage value of about 0.7 V at a normal temperature, this junction voltage value is reduced if the temperature is increased while other operating conditions (for example, the electrical current) remain the same as those prevailing during the measurement at the normal temperature. Actually, this variation is about -2 mV/$^\circ$C per diode unit. Thus, in order to obtain high precision in the temperature sensing, it is necessary to connect a plurality of stages of diodes (two stages in this example) as shown in Fig. 13A and Fig. 13B, or to connect at a subsequent stage an amplifying circuit having a lesser dependence of temperature on amplification rate.

In addition, another well-known temperature sensing device uses variations in the base-emitter junction voltage $V_{BE}$ of a bipolar transistor caused by temperature. However, since temperature sensing devices using pn-junction diodes or bipolar transistors are naturally manufactured by a bipolar process, it is difficult to install such devices on a CCD linear sensor in view of the manufacturing process. Even if the diode could be installed on a chip, it would be difficult to install a high precision amplifying circuit on the chip.

Furthermore, although it is widely known to perform temperature sensing using a thermistor, it would be necessary to install it on the chip in order to perform an accurate measurement of temperature for the monitored device. In a case where installation on the chip is required, it cannot be realized for the element normally called "a thermistor". For the above reasons, it is desired to develop a temperature sensing device which can be realized by a so-called MOS process.

### SUMMARY OF THE INVENTION

The present invention has been developed in view of the aforesaid problem. It is an object of the present invention to provide a temperature sensing device which can be installed on a chip together with the device to be monitored and a temperature variation of the monitored device can thus be detected accurately, a semiconductor device having this temperature sensing device installed therein, and an AF system using the semiconductor device.

2

The temperature sensing device of the present invention is constructed to have a potential control circuit having a first MOS transistor , the potential control circuit sensing the potential of a depletion region under the gate of the first MOS transistor and controlling the gate voltage of the first MOS transistor, and a second MOS transistor whose gate voltage is controlled by the potential control circuit and whose output serves as a temperature output.

The potential control circuit in the temperature sensing device having the aforesaid configuration detects a potential in the case of depletion in the gate of the first MOS transistor and regulates the gate voltage of the first MOS transistor, thereby setting the potential equal to a reference voltage (or a potential proportional to the reference voltage). An output of this potential control circuit is applied as the gate voltage of the second MOS transistor, thereby compensating for the temperature dependency of the threshold voltage Vth of the MOS transistor. Thus, only the drain current Ids of the MOS transistor has a temperature dependency and this drain current is utilized to measure temperature.

The semiconductor device according to the present invention is constructed such that the temperature sensing device having the aforesaid configuration is installed on the same chip. In addition, the AF system according to the present invention is constructed such that a solid-state imaging device installed on the same chip is used as an AF sensor.

## BRIEF DESCRIPTION OF THE DRAWINGS

Fig. 1 is a diagram illustrating the configuration of one preferred embodiment of the present invention.

Fig. 2 is a circuit diagram of one example of a potential control circuit in the case where NMOS transistors are used.

Fig. 3 is a circuit diagram of one example of a potential control circuit in the case where PMOS transistors are used.

Figs. 4A and 4B are sectional views and associated potential diagrams for showing portions of the MOS transistors M1, M2 in the respective potential-voltage conversion circuits of Figs. 2 and 3.

Fig. 5 is an input/output characteristic diagram of the potential control circuit.

Fig. 6 is a temperature characteristic diagram of the potential control circuit.

Fig. 7 is a temperature characteristic diagram illustrating the result of a simulation.

Fig. 8 is a diagram showing the configuration of an entire temperature sensing device embodying the present invention.

Fig. 9 is a diagram showing the configuration of a CCD linear sensor having a temperature sensing device of the present invention installed therein.

Fig. 10 is a schematic configuration view for showing an AF system in which a CCD linear sensor having the temperature sensing device of the present invention installed therein is used as an AF sensor.

Fig. 11 is a view illustrating a principle of auto-focusing operation.

Figs. 12A and 12B are circuit diagrams for showing a first example of the prior art.

Figs. 13A and 13B are circuit diagrams for showing a second example of the prior art.

## DESCRIPTION OF THE PREFERRED EMBODIMENTS

Referring now to the accompanying drawings, preferred embodiments of the present invention will be described in detail as follows.

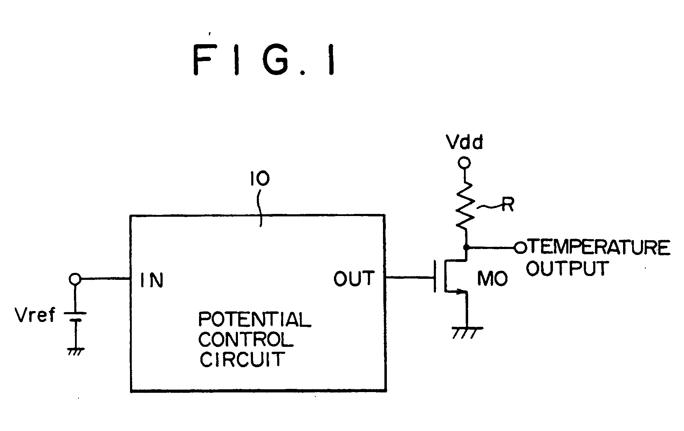

Fig. 1 is a diagram showing the configuration of one preferred embodiment of the present invention. In Fig. 1, the temperature sensing device of the preferred embodiment of the present invention is comprised of at least one MOS transistor M0 with its source connected to ground and its drain connected to a power supply Vdd through a reference resistor R, and a potential control circuit 10 operating to generate a potential, in the case of depletion under the gate of this MOS transistor M0, equal to a reference voltage Vref or a potential proportional to the reference voltage Vref. That is, a MOS process is carried out so as to provide an output which is dependent upon temperature.

In this case, different parameters of the MOS transistor are dependent upon temperature, namely the threshold voltage value Vth and the drain current Ids. In the preferred embodiment, a configuration utilizing a temperature variation of the drain current Ids is employed. In the case where the drain current Ids is used as the parameter which is dependent upon temperature, its output can be significantly increased by changing the size of the MOS transistor M0. For example, mere doubling of a channel width causes the current to double in value. This variation in current can be sensed as a voltage output through the reference resistor R and this voltage output becomes the temperature output.

During operation in a saturated region, this drain current Ids is expressed by Equation 2.

$$\text{Ids} = \frac{\mu \bullet \varepsilon_{0X} \bullet \varepsilon_0 W}{t_{0X} \bullet L} \bullet (V_{gs} - V_{th})^2 / 2 \qquad \text{Equation 2}$$

where, $\mu$ is electron mobility, $\varepsilon_{0X}$ is the dielectric constant, $\varepsilon_0$ is the vacuum dielectric constant ($8.85 \times 10^{-12}(F \cdot m^{-1})$), $t_{0X}$ is the film thickness of the gate oxidizing film, W is the channel width, L is the channel length and Vgs is the gate voltage.

However, in accordance with the above equation, electron mobility $\mu$ decreases as temperature is increased near a normal temperature so as to cause the drain current Ids to decrease, although a threshold voltage Vth is decreased in its own value, its negative may act to cause the drain current Ids to be increased. In view of this fact, in the preferred embodiment of the present invention, the potential control circuit 10 operates to cause the potential in the case of a depletion in a gate of the MOS transistor M0 (= Vgs - Vth) to be kept constant. Thereby the drain current Ids is set to have a temperature dependence only on electron mobility $\mu$.

The potential control circuit 10 is a circuit for controlling the gate voltage of the MOS transistor M0 in such a way that even if the power supply voltage Vdd or the threshold voltage value Vth varies, the potential in the case of depletion under the gate of the MOS transistor M0 will take the reference voltage value Vref. A practical circuit configuration of this potential control circuit 10 will be described as follows.

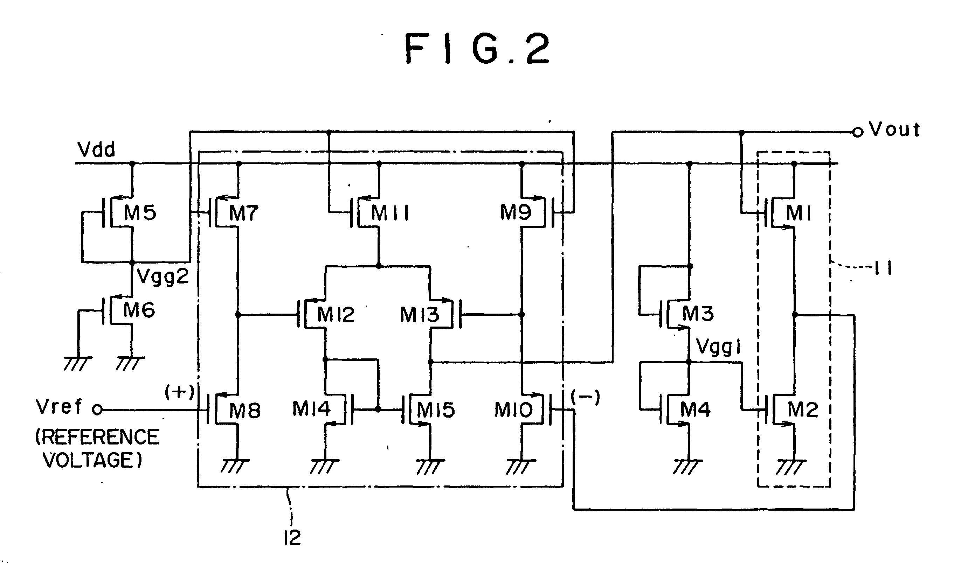

Fig. 2 is a circuit diagram of one example of the potential control circuit according to the invention, in a case where NMOS transistors are applied. In Fig. 2, a potential-voltage conversion circuit 11 is comprised of a driving side MOS transistor M1 and a load side MOS transistor M2 connected in series between the power supply Vdd and ground. A bias voltage Vgg1 is applied to the gate of the load side MOS transistor M2 by diode-connected MOS transistors M3, M4 connected in series between the power supply Vdd and the ground.

An output of this potential-voltage conversion circuit 11 is fed to the inverting (-) input of a comparator 12 and this is compared with a reference voltage Vref (or Vin) at the non-inverting (+) input of the comparator. To this comparator 12 is applied a bias voltage Vgg2 by diode-connected MOS transistors M5, M6 connected in series between the power supply Vdd and ground.

The comparator 12 is comprised of MOS transistors M7, M8 connected in series between the power supply Vdd and ground so as to constitute a (+) side input stage; the MOS transistors M9, M10 constituting a (-) side input stage; and the MOS transistors M12, M13 having their sources connected in common to perform a differential operation. The MOS transistor M11 serves as a current source for the former MOS transistors. The MOS transistors M14, M15 are connected between the drains of the respective MOS transistors M12, M13 and ground so as to constitute a current mirror circuit, wherein the bias voltage Vgg2 is applied to each of the gates of the MOS transistors M7, M9 and M11, respectively.

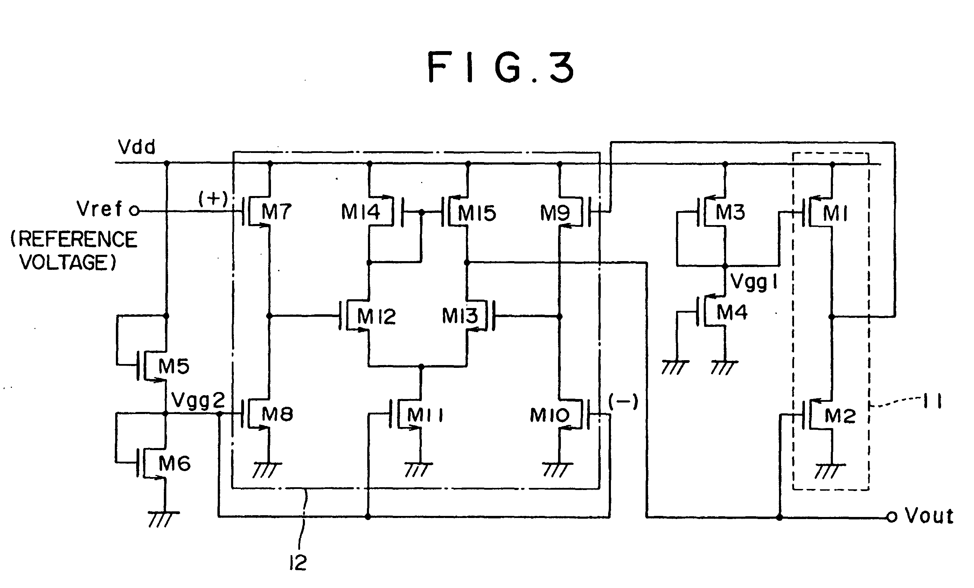

Fig. 3 is a circuit diagram for showing one example of the circuit configuration of the potential control circuit 10 in a case where PMOS transistors are applied. This potential control circuit 10 differs from the potential control circuit shown in Fig. 2 merely in that its polarity is reversed, basically the circuits have the same circuit configuration.

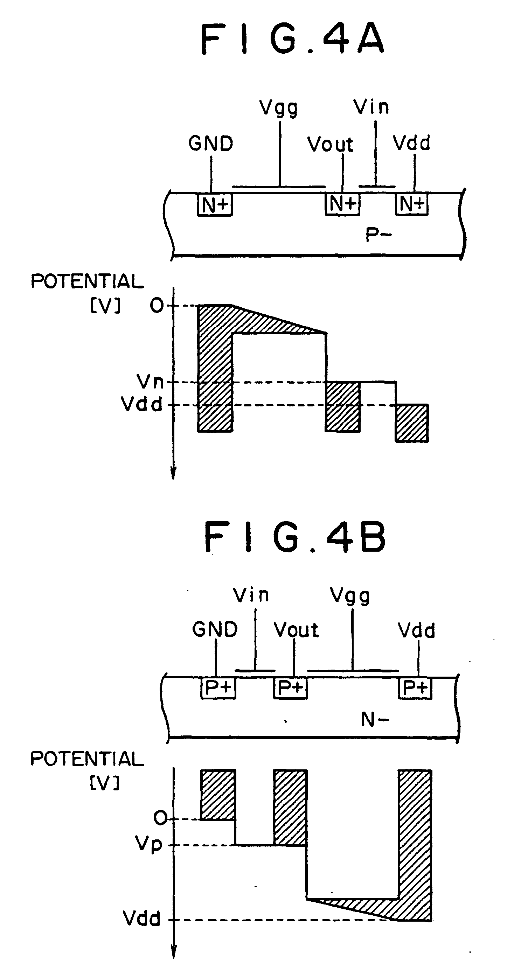

Fig. 4A and Fig. 4B are sectional views and potential diagrams of the MOS transistor portions M1, M2 in the potential-voltage conversion circuit 11. In the following description the case where the potential-voltage conversion circuit 11 is implemented using NMOS will be considered. In the case where the channel widths of the MOS transistors M1, M2 are W1, W2, respectively, and the channel lengths are defined as L1, L2, respectively, it is assumed that L1 is set to be low and L2 is set to be high. In one example, L2/L1 is set to be approximately 100.

With an arrangement such as described above, a fine current flows in the load side MOS transistor M2 and along with this flowing operation, a current flowing in the driving side MOS transistor M1 becomes a fine current. As a result, the potential Vn in the channel under the gate of the MOS transistor M1 becomes the output voltage Vout as it is. That is, the size ratio as described above is set so as to enable the potential in the case of depletion under the gate of the MOS transistor M1 to be detected as the output voltage Vout.

In the potential control circuit 10 having the aforesaid configuration, the potential-voltage conversion circuit 11 will detect the potential in the case of depletion under the gate of the MOS transistor M1 in view of the aforesaid principle. The output of this potential-voltage conversion circuit 11 is compared with the reference voltage Vref at the comparator 12, and the gate voltage of the MOS transistor M1 in the potential-voltage conversion circuit 11 is controlled by the output result of the comparison. With an arrangement such as the above, the potential in the case of depletion under the gate of the MOS transistor M1 is feedback controlled in such a way that it will be equal to the reference voltage Vref.

Then, the output voltage Vout of this potential control circuit 10 is supplied to the MOS transistor M0 as its gate voltage. In this case, there is used as the MOS transistor M0, a transistor having the same size as that of the MOS transistor M1 in the potential-voltage conversion circuit 11, and the potential in the case of depletion under the gate of the MOS transistor M0 is also controlled by the potential control circuit 10 in such a way that it will be equal to the reference voltage Vref.

The potential under the gate, in the case of depletion, of the MOS transistor M0 is kept at a specified voltage (the reference voltage Vref) even if either the power supply Vdd or the threshold value voltage Vth varies. As a result, the drain current Ids has a temperature dependence only on the electron mobility $\mu$. Accordingly, when the temperature changes, the drain current Ids in the MOS transistor M0 changes, and this varying current component is obtained as a voltage output through the reference resistor R to become a temperature output.

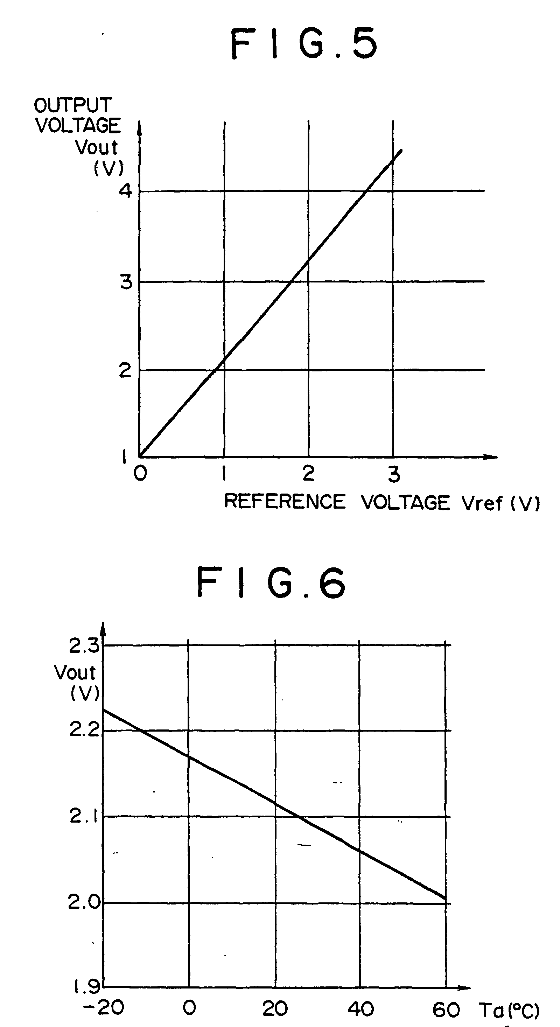

Fig. 5 illustrates the characteristic of reference voltage Vref against output voltage Vout in the potential control circuit 10. This characteristic is an example where Vth = 1V. The reason why the gradient of the characteristic is not 1 depents upon a back-gate effect or the like. In addition, in Fig. 6 there is indicated a temperature characteristic (the reference voltage Vref being kept constant) in the potential control circuit 10. The gate voltage Vgs of the MOS transistor M0 is controlled by the potential control circuit 10. Therefore, as the temperature is increased, the gate voltage Vgs of the MOS transistor M0 follows the temperature variation of the threshold voltage Vth and is decreased. As a result, value (Vgs - Vth) in Equation 2 is kept constant.

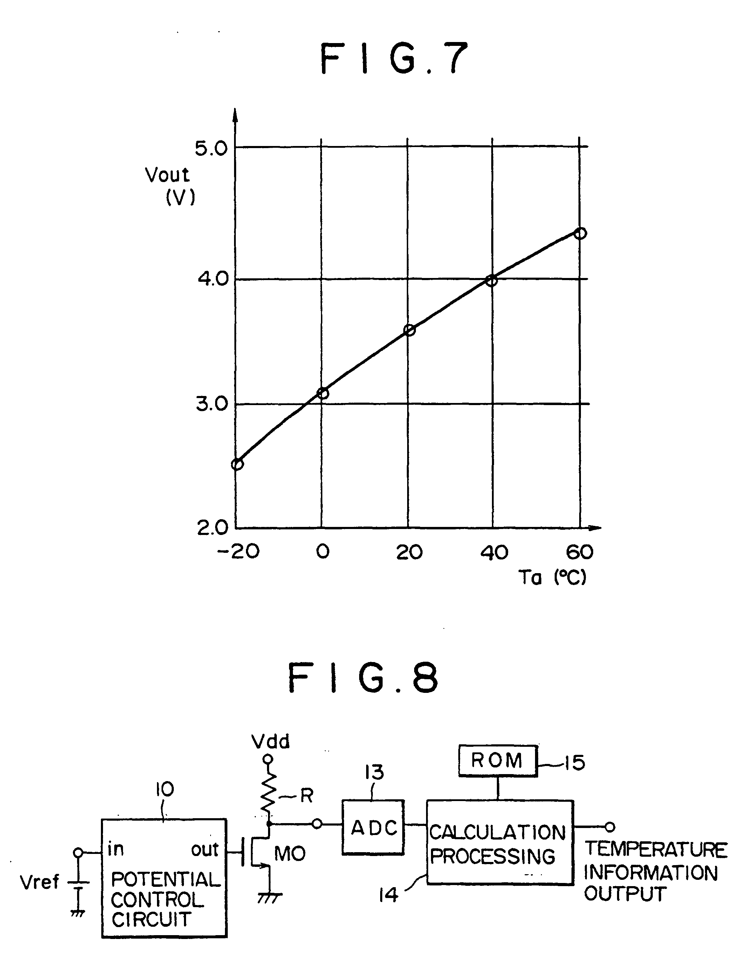

Fig. 7 is a temperature characteristic diagram indicating a result of an actual simulation in the preferred embodiment. As is apparent from this temperature characteristic diagram, the temperature coefficient is several tens mV/ °C and, in practice, a high precision circuit can be realized. If the dynamic range of the output is wide, several hundreds mV/°C can also be realized.

In Fig. 8 there is indicated the configuration of the whole of an embodiment of temperature sensing device according to the present invention. In Fig. 8, the temperature output, detected as a voltage output through the reference resistor R, is changed into digital form by an A/D converter 13 and supplied to a calculation processing circuit 14. An actual temperature value is calculated in this calculation processing circuit 14 by reference to the output data of the A/ D converter 13 and by referring to a table of temperature coefficients and output voltages at a normal temperature stored in advance in ROM 15, and then this calculated temperature serves as a temperature information output.

As described above, a MOS transistor M0 is used, a variation of the drain current Ids having a temperature dependency is detected through a reference resistor R while the potential in the case of depletion under the gate of this MOS transistor M0 is being controlled to be equal to the reference voltage Vref, and the detected voltage output serves as a temperature output. Accordingly, the MOS transistor M0 actually performing the temperature sensing and the potential control circuit 10 can be installed on the chip of the monitored device. As a result, variations in the temperature of the monitored device can be detected more accurately.

In addition, although in the preferred embodiment of the present invention the varying current in the MOS transistor M0 is converted into a voltage through the resistor R and outputted as a temperature output, it is not necessarily required to use a voltage output. It is also possible to output the current flowing either in the drain or the source of the MOS transistor M0 as the temperature output.

Although in the aforesaid preferred embodiment the potential in the case of depletion under the gate of the MOS transistor M0 is controlled to become equal to a fixed reference voltage Vref, it is also possible to make the reference voltage Vref variable in response to temperature and further to control the reference voltage Vref to decrease as the temperature increases. In a controlling operation such as the above, it is possible to further increase the detection sensitivity of surrounding temperature.

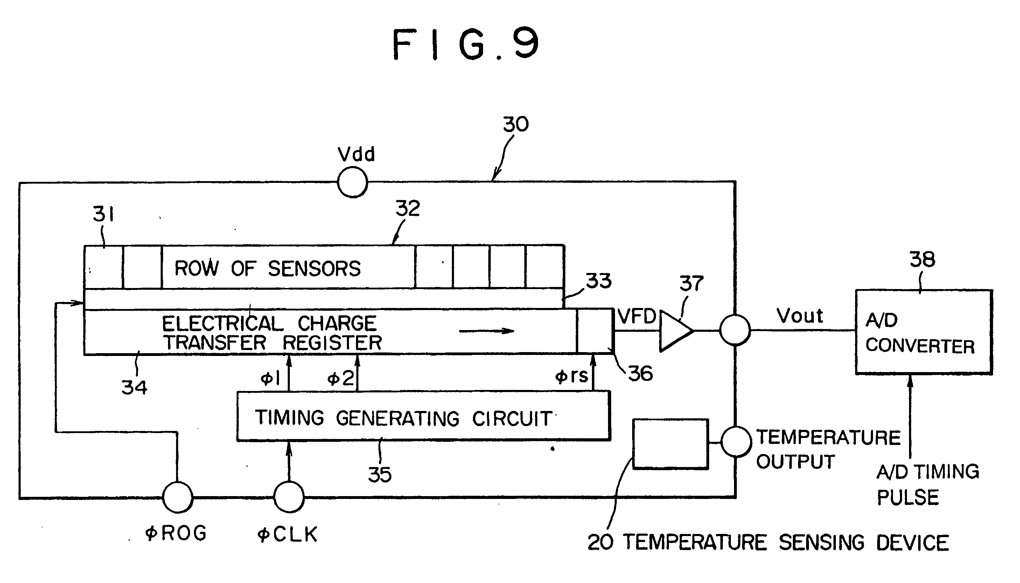

Fig. 9 is a diagram illustrating the configuration of a CCD linear sensor, for example, having the temperature sensing device 20 of the present invention installed therein. In Fig. 9, a CCD linear sensor 30 is configured to have a row of linearly arranged sensors 32 in which a plurality of (for example, 2,000 ) photoelectrical conversion segments (pixels) 31 is provided for converting incident light into a signal charge whose amount corresponds to the quantity of light, and have a charge transfer register 34 for transferring the signal charge read out from each of the light receiving parts 31 in the row of sensors 32 through a reading-out gate 33.

With a configuration such as the above, a reading-out operation for signal charge through the reading-out gate part 33 is carried out by an operation in which a reading-out gate pulse φROG is supplied from an external source. In addition, the charge transfer register 34 is driven in two-phases by transfer clocks φ1 and φ2. The two-phase transfer clocks φ1 and φ2 are generated at a timing generating circuit 35, having the CCD chip comprised of the row of sensors 32, the reading-out gate 33 and the charge transfer register 34 formed thereon, with reference to a reference clock φCLK supplied from an external source.

The terminal end of the charge transfer register 34 in the direction of charge transfer is provided with a charge-voltage converting part 36 comprised of a floating diffusion amplifier, for example, for detecting the signal charge transferred by the charge transfer register 34 and converting it into a voltage. A rear stage of the charge voltage converting part 36 is provided with a buffer 37 comprised of a source follower circuit, for example. This buffer 37 is also installed on the CCD chip in the same manner as the timing generating circuit 35. With an arrangement such as the above, the CCD linear sensor 30 is configured and its output signal Vout is changed into a digital form by the A/D converter 38 arranged outside the CCD chip.

In addition, a temperature sensing device 20 for use in sensing the temperature of its surroundings is installed in the chip of the CCD linear sensor 30. As this temperature sensing device 20, there is employed the device shown in Fig. 1, i.e. a temperature sensing device for outputting a temperature dependent output, using the MOS process. Employment of this temperature sensing device enables this device to be installed in the CCD chip of the CCD sensor device, whereby temperature of the CCD linear sensor 30 can be detected more accurately.

Although in the above preferred embodiment the temperature sensing device 20 is installed on the CCD linear sensor 30, the invention is not limited to installation on a CCD linear sensor 30, the temperature sensing device may be installed on a CCD area sensor or a CCD delay line. In the case of the CCD delay sensor, for example, although the total amount of delay (comprised of a delay amount determined by a certain clock and a delay amount due to buffering) is changed in response to temperature, installation of the temperature sensing device 20 on the chip enables temperature variations of the CCD delay line to be detected more accurately and concurrently a more precise delay amount can be attained by performing a fine adjustment of the delay amount.

In addition, the present invention is not limited to use in CCD devices, but can be executed in such a way that the temperature sensing device can be installed on an amplifying type solid-state imaging device such as a MOS type image sensor or a BASIS (Base Stored Image Sensor) type image sensor or, in general, on semiconductor devices such as MOS circuits or the like, and a variation in the output of a semiconductor device due to a temperature change can be corrected with reference to the measured temperature information.

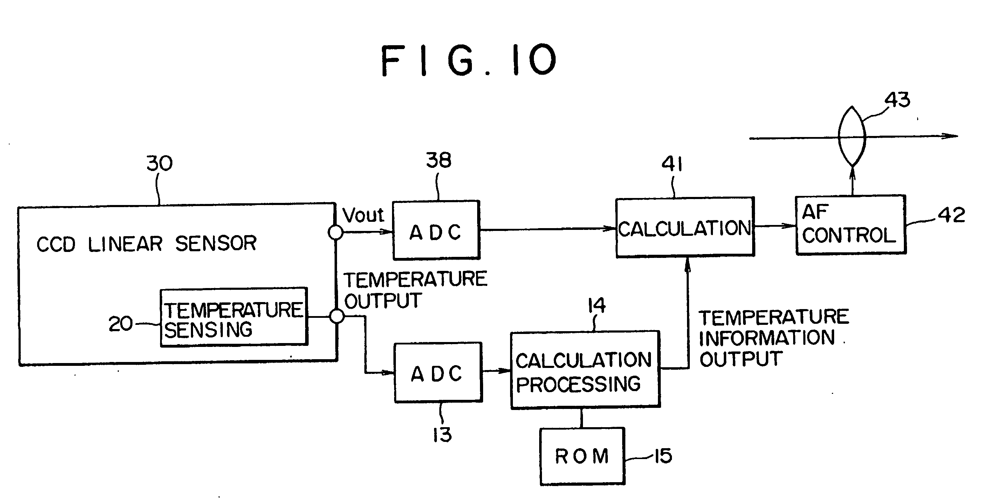

Fig. 10 is a schematic configuration view for showing one example of an AF system in which the CCD linear sensor having the temperature sensing device 20 of the present invention installed therein, for example, is used as the AF sensor. In Fig. 10, the same component parts as those of Figs. 8 and 9 are indicated using the same reference numbers. In Fig. 10, the output signal Vout of the CCD linear sensor 30 is changed into digital form by the A/D converter 38, thereafter this signal is supplied to a calculation circuit 41 comprised of a microcomputer. In Fig. 10, only one CCD linear sensor 30 is shown, although as is apparent from the auto-focusing principle diagram of Fig. 11, two CCD linear sensors are used for calculating an actual focusing displacement amount.

In turn, as already illustrated in Fig. 8, a temperature output from the temperature sensing device 20 installed on the CCD linear sensor 30 is changed into digital form by the A/D converter 13. Thereafter an actual temperature is calculated in the calculation processing circuit 14 with reference to the table of temperature coefficients and output voltages stored in advance in the ROM 15. The calculated temperature is then supplied to the calculation circuit 41 as a temperature information output.

In this calculation circuit 41, a focusing displacement amount is calculated in response to the output signal Vout of the CCD linear sensor 30 and concurrently the calculated focusing displacement amount is corrected with reference to the temperature information output from the calculation processing circuit 14. Then, the AF control circuit 42 performs a focusing adjustment by moving the lens 43 in the optical axis direction in response to the temperature-corrected focusing displacement amount.

As described above, the CCD linear sensor 30 having the temperature sensing device 20 installed on its chip is used as the AF sensor in the AF system in order to enable the temperature of the AF sensor itself to be measured more accurately. It is therefore possible to improve correction accuracy for errors caused by strain (aberration) variation in an optical system of an applied lens or the like. Accordingly, a more accurate auto-focusing control can be attained.

As described above, in accordance with the present invention, temperature is detected with reference to varying current in MOS transistor having a temperature dependency, while a potential in the case of depletion under the gate of the MOS transistor is made equal to a reference voltage. This temperature sensing device therefore can be manufactured on the chip of the monitored device by a MOS process. As a result, temperature variation of the monitored device can be detected more accurately.

**Claims**

1.    A temperature sensing device comprising:

    a potential control circuit (10) having a first MOS transistor (M1), for sensing the potential in the case of depletion under the gate of this first MOS transistor and for controlling the gate voltage of said first MOS transistor (M1) with reference to this detected potential; and
    a second MOS transistor (M0) the gate voltage of which is controlled by said potential control circuit (10) and having its output used as a temperature output.

2.    A temperature sensing device as set forth in clam 1, wherein a current flowing in either a drain or a source of said second MOS transistor (M0) serves as said temperature output.

3.    A temperature sensing device as set forth in clam 1, wherein there is provided a reference resistor connected in series with said second MOS transistor (M0) and a current flowing in either a drain or a source of said second MOS transistor is extracted as a voltage output through said reference resistor and serves as said temperature output.

4.    A temperature sensing device as set forth in claim 1, 2 or 3, wherein said potential control circuit (10) compares said detected potential with a reference voltage (Vref) and controls a gate voltage of said first MOS transistor (M1) in such a way that it will be equal to said reference voltage (Vref) or to a potential proportional to said reference voltage.

5. A temperature sensing device as set forth in clam 4, wherein the reference voltage is made variable in response to temperature.

6. A temperature sensing device as set forth in any previous claim, wherein there is provided an A/D converter (13) for changing said temperature output into a digital form and a calculation processing circuit (14) for calculating an actual temperature as a temperature information output based on output data of said A/D converter (13) with reference to a table of temperature coefficients and output voltages in normal temperature stored in a memory (15).

7. A semiconductor device, wherein

a potential control circuit (10) having a first MOS transistor (M1), for sensing a potential in the case of depletion under the gate of this first MOS transistor (M1) and for controlling a gate voltage of said first MOS transistor in reference to this detected potential, and
a second MOS transistor (M0) the gate voltage of which is controlled by said potential control circuit (10) and having its output serving as a temperature output are installed on the same chip as the semiconductor device.

8. A semiconductor device as set forth in claim 7, wherein said semiconductor device is a CCD (30).

9. A semiconductor device as set forth in claim 7, selected from a MOS type image sensor, a BASIS type image sensor and a MOS circuit.

10. An auto-focusing system, wherein a solid-state imaging device is used as an auto-focusing sensor and, on the same chip, there is provided:

a potential control circuit (10) having a first MOS transistor (M1), for sensing a potential in the case of depletion under the gate of this first MOS transistor and for controlling the gate voltage of said first MOS transistor with reference to this detected potential, and
a second MOS transistor (M0) the gate voltage of which is controlled by said potential control circuit (10) and with its output serving as a temperature output.

11. An auto-focusing system as set forth in claim 10, wherein there are provided a first calculation circuit (41) for calculating a focusing displacement in response to an output signal of said solid-state imaging device (30), and a second calculation processing circuit (14) for calculating an actual temperature as a temperature information output based on said temperature output with reference to a table of temperature coefficients and output voltages at a normal temperature stored in a memory (15) and said focusing displacement amount is corrected in response to said temperature information output.

**Patentansprüche**

1. Temperaturfühlereinrichtung, aufweisend:

eine einen ersten MOS-Transistor (M1) aufweisende Potentialsteuerschaltung (10) zum Abfühlen des Potentials im Fall einer Verarmung unter dem Gate dieses ersten MOS-Tansistors und zur Steuerung der Gatespannung des ersten MOS-Transistors (M1) in Bezug auf dieses detektierte Potential, und
einen zweiten MOS-Transistor (M0), dessen Gatespannung durch die Potentialsteuerschaltung (10) gesteuert ist und dessen Ausgangssignal als ein Temperaturausgangsignal verwendet ist.

2. Temperaturfühlereinrichtung nach Anspruch 1, wobei ein in entweder einer Drain oder einer Source des zweiten MOS-Transistors (M0) fließender Strom als das Temperaturausgangssignal dient.

3. Temperaturfühlereinrichtung nach Anspruch 1, wobei ein Referenzwiderstand vorgesehen ist, der in Serie mit dem zweiten MOS-Transistor (M0) geschaltet ist, und ein in entweder einer Drain oder einer Source des zweiten MOS-Transistors fließender Strom durch den Referenzwiderstand als ein Spannungsausgangssignal extrahiert wird und als das Temperaturausgangssignal dient.

**4.** Temperaturfühlereinrichtung nach Anspruch 1, 2 oder 3, wobei die Potentialsteuerschaltung (10) das detektierte Potential mit einer Referenzspannung (Vref) vergleicht und eine Gatespannung des ersten MOS-Transistors (M1) derart steuert, dass sie gleich der Referenzspannung (Vref) oder einem zur Referenzspannung proportionalen Potential ist.

**5.** Temperaturfühlereinrichtung nach Anspruch 4, wobei die Referenzspannung in Reaktion auf die Temperatur variabel gemacht ist.

**6.** Temperaturfühlereinrichtung nach einem der vorhergehenden Ansprüche, wobei ein A/D-Wandler (13) zur Änderung des Temperaturausgangssignals in eine digitale Form und eine Berechnungsverarbeitungsschaltung (14) zur Berechnung einer aktuellen Temperatur als ein Temperaturinformationsausgangssignal auf der Basis von Ausgangsdaten des A/D-Wandlers (13) mit Bezugnahme auf eine in einem Speicher (15) gespeicherte Tabelle von Temperaturkoeffizienten und Ausgangsspannungen bei normaler Temperatur vorgesehen sind.

**7.** Halbleitereinrichtung, wobei

eine einen ersten MOS-Transistor (M1) aufweisende Potentialsteuerschaltung (10) zum Abfühlen eines Potentials im Fall einer Verarmung unter dem Gate dieses ersten MOS-Transistors (M1) und zur Steuerung einer Gatespannung des ersten MOS-Transistors in Bezug auf dieses detektierte Potential und
ein zweiter MOS-Transistor (M0), dessen Gatespannung durch die Potentialsteuerschaltung (10) gesteuert ist und bei dem sein Ausgangssignal als ein Temperaturausgangssignal dient, auf dem gleichen Chip als die Halbleitereinrichtung installiert sind.

**8.** Halbleitereinrichtung nach Anspruch 7, wobei die Halbleitereinrichtung eine CCD (30) ist.

**9.** Halbleitereinrichtung nach Anspruch 7, ausgewählt aus einem MOS-Typ-Bildsensor, einem BASIS-Typ-Bildsensor und einer MOS-Schaltung.

**10.** Autofokussierungssystem, wobei eine Festkörper-Abbildungseinrichtung als ein Autofokussierungssensor verwendet ist und auf dem gleichen Chip vorgesehen sind:

eine einen ersten MOS-Transistor (M1) aufweisende Potentialsteuerschaltung (10) zum Abfühlen eines Potentials im Fall einer Verarmung unter dem Gate dieses ersten MOS-Transistors und zur Steuerung der Gatespannung des ersten MOS-Transistors in Bezug auf dieses detektierte Potential und
ein zweiter MOS-Transistor (M0), dessen Gatespannung von der Potentialsteuerschaltung (10) gesteuert ist und dessen Ausgangssignal als ein Temperaturausgangssignal dient.

**11.** Autofokussierungssystem nach Anspruch 10, wobei vorgesehen sind: eine erste Berechnungsschaltung (41) zur Berechnung einer Fokussierungsverschiebung in Reaktion auf ein Ausgangssignal der Festkörper-Abbildungseinrichtung (30) und eine zweite Berechnungsverarbeitungsschaltung (14) zur Berechnung einer aktuellen Temperatur als ein Temperaturinformationsausgangssignal auf der Basis des Temperaturausgangssignals unter Bezugnahme auf eine in einem Speicher (15) gespeicherte Tabelle von Temperaturkoeffizienten und Ausgangsspannungen bei normaler Temperatur, und wobei der Fokussierungsverschiebungsbetrag in Reaktion auf das Temperaturinformationsausgangssignal korrigiert wird.

**Revendications**

**1.** Dispositif de détection de température comprenant :

un circuit de commande de potentiel (10) qui comporte un premier transistor MOS (M1) pour détecter le potentiel dans le cas d'un appauvrissement au-dessous de la grille de ce premier transistor MOS et pour commander la tension de grille dudit premier transistor MOS (M1) par référence à ce potentiel détecté ; et
un second transistor MOS (M0) dont la tension de grille est commandée par ledit circuit de commande de potentiel (10) et qui a son signal de sortie qui est utilisée en tant que signal de sortie de température.

**2.** Dispositif de détection de température selon la revendication 1, dans lequel un courant qui circule dans soit un drain, soit une source dudit second transistor MOS (M0) joue le rôle dudit signal de sortie de température.

**3.** Dispositif de détection de température selon la revendication 1, dans lequel est prévue une résistance de référence qui est connectée en série audit second transistor MOS (M0) et un courant qui circule dans soit un drain, soit une source dudit second transistor MOS est extrait en tant que signal de sortie de tension au-travers de ladite résistance de référence et joue le rôle dudit signal de sortie de température.

**4.** Dispositif de détection de température selon la revendication 1, 2 ou 3, dans lequel ledit circuit de commande de potentiel (10) compare ledit potentiel détecté à une tension de référence (Vref) et commande une tension de grille dudit premier transistor MOS (M1) de telle sorte qu'elle soit égale à ladite tension de référence (Vref) ou à un potentiel qui est proportionnel à ladite tension de référence.

**5.** Dispositif de détection de température selon la revendication 4, dans lequel la tension de référence est rendue variable en réponse à la température.

**6.** Dispositif de détection de température selon l'une quelconque des revendications précédentes, dans lequel sont prévus un convertisseur analogique - numérique ou A/N (13) pour modifier ledit signal de sortie de température selon une forme numérique et un circuit de traitement de calcul (14) pour calculer une température réelle en tant que signal de sortie d'information de température sur la base de données de sortie dudit convertisseur A/N (13) par référence à une table de coefficients de température et de tensions de sortie à une température normale comme stocké dans une mémoire (15).

**7.** Dispositif à semiconducteur, dans lequel :

un circuit de commande de potentiel (10) qui comporte un premier transistor MOS (M1) pour détecter un potentiel dans le cas d'un appauvrissement au-dessous de la grille de ce premier transistor MOS (M1) et pour commander une tension de grille dudit premier transistor MOS par référence à ce potentiel détecté ; et
un second transistor MOS (M0) dont la tension de grille est commandée par ledit circuit de commande de potentiel (10) et qui a son signal de sortie qui joue le rôle de signal de sortie de température
sont installés sur la même puce que le dispositif à semiconducteur.

**8.** Dispositif à semiconducteur selon la revendication 7, dans lequel ledit dispositif à semiconducteur est un CCD (30).

**9.** Dispositif à semiconducteur selon la revendication 7, choisi parmi un capteur d'image du type MOS, un capteur d'image du type BASIS et un circuit MOS.

**10.** Système d'auto-focalisation dans lequel un dispositif imageur à l'état solide est utilisé en tant que capteur d'auto-focalisation et, sur la même puce, sont prévus :

un circuit de commande de potentiel (10) qui comporte un premier transistor MOS (M1) pour détecter un potentiel dans le cas d'un appauvrissement au-dessous de la grille de ce premier transistor MOS et pour commander une tension de grille dudit premier transistor MOS par référence à ce potentiel détecté ; et
un second transistor MOS (M0) dont la tension de grille est commandée par ledit circuit de commande de potentiel (10) et qui a son signal de sortie qui joue le rôle de signal de sortie de température.

**11.** Système d'auto-focalisation selon la revendication 10, dans lequel sont prévus un premier circuit de calcul (41) pour calculer un déplacement de focalisation en réponse à un signal de sortie dudit dispositif imageur à l'état solide (30) et un second circuit de traitement de calcul (14) pour calculer une température réelle en tant que signal de sortie d'information de température sur la base dudit signal de sortie de température par référence à une table de coefficients de température et de tensions de sortie à une température normale comme stocké dans une mémoire (15), et ladite valeur de déplacement de focalisation est corrigée en réponse audit signal de sortie d'information de température.

# F I G. I

# F I G. 2

# F I G. 3

EP 0 773 437 B1

# F I G . 4A

# F I G . 4B

# F I G.5

OUTPUT
VOLTAGE
Vout
(V)

REFERENCE VOLTAGE Vref (V)

# F I G.6

Vout
(V)

Ta(°C)

# FIG.7

# FIG.8

# FIG.9

EP 0 773 437 B1

# FIG. 10

# F I G. 11

# F I G . 12A

# F I G . 12B

# F I G . 13A

# F I G . 13B